# EUROPEAN PATENT APPLICATION

(11) **EP 3 290 914 A1**
(43) Date of publication of application: **07.03.2018**
(21) Application number: 17185192.6
(22) Date of filing: 07.08.2017
(51) Int. Cl.: G01N 27/12, H01L 29/93

(54) **METHODS AND VARACTOR BASED SENSOR DEVICES FOR SENSING FLUID PROPERTIES**

(30) Priority: 31.08.2016 US 201615252621
(71) Applicant: NXP USA, Inc., Austin TX 78735 (US)
(72) Inventor: Hoque, Md. M, Redhill, Surrey RH1 1QZ (GB); Chen, Weize, Redhill, Surrey RH1 1QZ (GB); Parris, Patrice M., Redhill, Surrey RH1 1QZ (GB)
(74) Representative: Miles, John Richard

(57) **Abstract**

An ion sensor (104) for sensing ions in a fluid includes a Metal-Oxide Semiconductor (MOS) varactor (203) formed in and on a semiconductor substrate (200) having a gate dielectric (210) over the semiconductor substrate, a gate (212) over the gate dielectric, a well region (202) in the substrate under the gate dielectric, and source/drain regions (204, 206) in the well region, wherein the well region and the source/drain regions are of a same conductivity type; and a sense electrode (222) coupled to the MOS varactor, wherein the capacitance of the gate dielectric of the varactor changes when the sense electrode interacts with ions in the fluid. Alternatively, resistance of the well region changes when the sense electrode interacts with ions in the fluid, affecting a change in a quality factor of an inductor.

## Description

### FIELD

The present disclosure relates generally to fluid sensors and more particularly to methods and sensor devices used to sense and communicate fluid properties or characteristics.

### BACKGROUND

Integrated circuits (ICs) are currently used to sense some properties of a fluid. For example, Ion-Sensitive Field Effect Transistors (ISFETs) fabricated using complementary metal-oxide semiconductor (CMOS) processing technology are used to sense an ion concentration of an electrolytic solution (i.e., ion bearing fluid). More particularly, the ISFET is a MOSFET formed on a substrate, such as silicon, and comprises a source and drain region with a channel therebetween. The ISFET further comprises a floating gate region that is electrically connected to ion bearing fluid via a conductive sense electrode and one or more other metal interconnects or structures. During operation of the ISFET, in general, the ion concentration within the fluid results in a corresponding electrical bias of the floating gate. This bias results in a measurable change in channel conductivity between the source and drain. In this manner, it can be said that the ISFET directly senses the ion concentration of the fluid through its source/drain channel conductivity.

Ion sensitive devices that can detect the type and concentration of chemical and biological species are used in a variety of applications. Some applications involve dangerous, hazardous, and/or hard-to-access locations where power and signal connections are difficult or impossible to make.

### BRIEF DESCRIPTION OF THE DRAWINGS

The accompanying figures, where like reference numerals refer to identical or functionally similar elements throughout the separate views, together with the detailed description below, are incorporated in and form part of the specification, and serve to further illustrate embodiments of concepts that include the claimed invention, and explain various principles and advantages of those embodiments.
FIG. 1 illustrates a block diagram of a radio frequency system in a package for monitoring and communicating one or more properties of a fluid, in accordance with an embodiment.
FIG. 2 is a conceptual cross-sectional view of an ion sensor for sensing one or more properties of a fluid, in accordance with selected embodiments.
FIG. 3 is a conceptual cross-sectional view of an ion sensor for sensing one or more properties of a fluid, in accordance with other selected embodiments.
FIG. 4 is a conceptual cross-sectional view of an ion sensor for sensing one or more properties of a fluid, in accordance with other selected embodiments.
FIG. 5 is a conceptual top view of an embodiment of a capacitor that can be used in the ion sensor of FIG. 4.
FIG. 6 is a conceptual cross-sectional view of an ion sensor for sensing one or more properties of a fluid, in accordance with other selected embodiments.
FIG. 7 is a conceptual cross-sectional view of an ion sensor for sensing one or more properties of a fluid, in accordance with other selected embodiments.

Embodiments of the present invention are illustrated by way of example and are not limited by the accompanying figures, in which like references indicate similar elements. Skilled artisans will appreciate that elements in the figures are illustrated for simplicity and clarity and have not necessarily been drawn to scale. For example, the dimensions of some of the elements in the figures may be exaggerated relative to other elements to help improve the understanding of embodiments of the present invention.

The apparatus and method components have been represented where appropriate by conventional symbols in the drawings, showing only those specific details that are pertinent to understanding the embodiments of the present invention so as not to obscure the disclosure with details that will be readily apparent to those of ordinary skill in the art having the benefit of the description herein.

### DETAILED DESCRIPTION

In accordance with embodiments disclosed herein remote radio frequency (RF) ion detection devices and methods allow easy ion detection from locations that are difficult to access. The devices can detect and measure the ion concentration of any fluid or substance. Along with sensing and measuring capabilities, the device can transmit and receive data from a remote location. The remote detection and monitoring capability facilitates continuous monitoring in hard-to-access locations. Since all components are provided within a single device, maintenance complexity and cost are reduced. Most common remote RF ion detectors use discrete inductive or capacitive elements. However, when the RF ion detecting elements are integrated with standard complementary metal oxide semiconductor (CMOS) processing as disclosed herein, the advantages of reduced size and low cost system are realized. The ion sensor can be fabricated along with a microcontroller and non-volatile memory on a single substrate. Characterization data and calibration coefficients can be stored on the device before deployment to enable the device to compare sensed data with data for known compounds. The device can further be given a unique address to enable the device to be queried remotely.

In some embodiments, the ion-sensing device includes a MOS varactor with a gate connected to a sensing electrode to detect the ion concentration of any fluid. The ion interaction of the sensing plate modulates the capacitance of the MOS varactor. The MOS varactor can be a part of an integrated circuit module that can detect the fluid property by monitoring the change in capacitance and comparing the sensing component(s) with matched component(s). In other embodiments, the sensing device includes an ion-detecting inductor whose substrate is connected to a sensing plate to detect the ion concentration of any fluid. The ion interaction of the sensing plate modulates the resistance of the substrate, which results in a corresponding change in the quality factor of the inductor. The RF ion detection devices can be used in a variety of chemical, medical, agricultural, biological, and various other applications to detect and monitor food quality, mineral levels, chemical levels, disease, and other characteristics that can be identified with a unique electrical signature. Additionally, the sense electrode can be coated with materials sensitive to specific ions and molecules in order to detect or obtain a specific electrical signature.

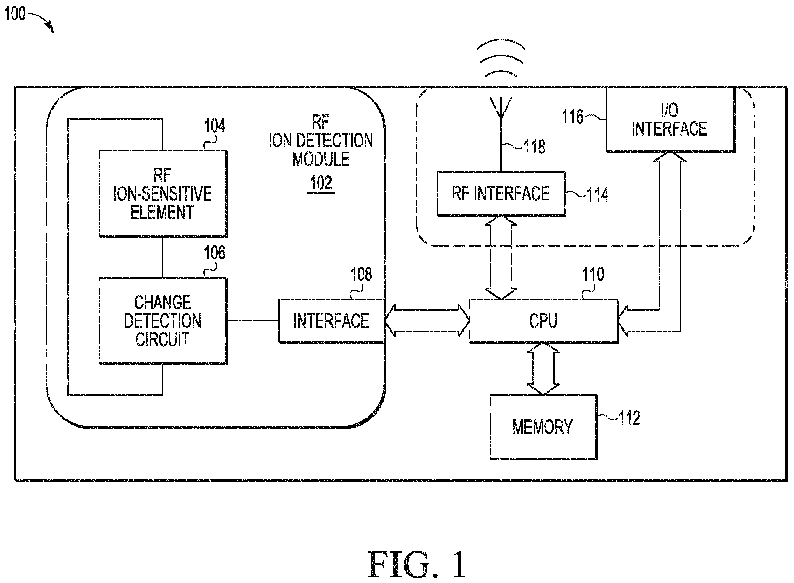

FIG. 1 illustrates a block diagram of a packaged radio frequency (RF) ion detection system 100 for monitoring and communicating one or more properties of a fluid, in accordance with selected embodiments. Detection system 100 includes RF ion detection module 102 with an RF ion-sensitive element 104 coupled to communicate with change detection circuit 106, and interface 108 coupled to enable change detection circuit 106 to communicate with central processing unit (CPU) 110. One or more memory devices 112 can be coupled to send and receive data from CPU 110. RF interface 114 and/or input/output (I/O) interface 116 can be configured to communicate with components external to system 100 and with CPU 110. RF ion detection system 100 can further include, if desired, additional components and functionality which are not illustrated, for example, a speaker, a text and/or image display, a user input device such as buttons or a keypad, and/or other suitable components and functionality.

The components of RF ion detection system 100 including RF ion-sensitive element 104, change detection circuit 106, interface 108, CPU 110, memory device 112, RF interface 114 and/or I/O interface 116 are formed on the same substrate or IC chip and can communicate wirelessly or via a wired link. Any suitable RF transmission circuits, protocols and techniques can be used for this purpose. RF ion detection system 100 is manufactured using any suitable semiconductor device fabrication process (also referred to herein as an IC fabrication process), including known IC fabrication processes such as ones implementing CMOS technology. As used herein, the term IC fabrication process also includes the step of packaging. The IC fabrication process begins with a substrate comprising semiconductor material such as Silicon, Germanium, or other semiconductor material and includes multiple process steps used to create interconnected electronic components on the substrate. These process steps include, for example, doping or ion implantation, etching, deposition of various layers of materials, and photolithographic patterning. The process steps result in interconnected electronic components being formed in multiple layers of material on a substrate, wherein the multiple layers include for example, polysilicon, metal, dielectric (such as SiO₂), and passivation. As used herein, all of the electronic components formed on a single IC chip that is fabricated starting with a given piece of substrate are referred to, in general, as being "formed on" that piece of substrate. Note that components described herein may be formed on one or more substrates, however.

Change detection circuit 106 comprises a set of electronic components formed on a substrate. The particular set of electronic components is determined by the type or types of ion-sensitive element 104 properties that the change detection circuit 106 is designed to detect or measure. Change detection circuit 106 can include, but is not limited to, receivers, low noise amplifiers, frequency (e.g., radio frequency (RF)) sensing circuits, digital signal processors (DSPs), analog to digital converter, microcontroller units (MCUs), etc. Accordingly, depending on the implementation of RF ion-sensitive element 104, change detection circuit 106 contains one or more active and/or passive components such as transistors (e.g., metal-oxide field effect transistors (MOSFETs)), resistors, capacitors, inductors, etc. As such, some portions of the change detection circuit 106 are formed directly in the substrate (including drain and source regions of a MOSFET for instance) through doping and ion implantation. Portions of ion-sensitive element 104 (such as gate regions of a MOSFET or plates and dielectric of a capacitor, as examples) are formed in other material layers deposited on the substrate. These other material layers comprise one or more layers of polysilicon, dielectric, and/or metal layers in various types, amounts and combinations depending on the particular electronic components and interconnects formed therein.

Ion-sensitive element 104 comprises at least one (i.e., one or more) electronic components that operate to interact with a fluid such as by contacting, penetrating or extending a given depth into the fluid. The fluid affects one or more intrinsic properties of ion-sensitive element 104. In one embodiment, RF ion-sensitive element 104 comprises at least one inductor component. For example, the at least one inductor component comprises a first inductor component having a first geometry and a second inductor component having a second geometry that is different than the first geometry of the first inductor component. In a further embodiment, ion-sensitive element 104 comprises at least one capacitor (C) component such as a capacitor. For example, the at least one capacitor component comprises a first capacitor component having a first geometry and a second capacitor component having a second geometry that is different than the first geometry of the first capacitor component. In yet another embodiment, RF ion sensor system 100 can include at least one inductor component and at least one capacitor component to form one or more LC or RLC circuits.

As stated above, and in accordance with the present teachings, RF ion-sensitive element 104, change detection circuit 106, interface 108, CPU 110, memory device 112, RF interface 114 and/or I/O interface 116 are coupled within the same RF ion detection system 100. RF ion detection system 100 can include packaging material configured or designed to hold, contain, support, mount, enclose, encapsulate, or seal the components of RF ion detection system 100 as a single unit.

Ion-sensitive element 104 and change detection circuit 106 are communicatively coupled to enable change detection circuit 106 to determine a change in a property of ion-sensitive element 104 as results from its interaction with the fluid. Coupling comprises a direct electrical connection through a set of one or more electrical connectors formed in one or more metal layers of RF ion detection system 100, wherein the metal layer(s) are interconnected through wires, interconnects, or vias (vertical interconnect accesses). The interconnects may be direct vertical connections between circuit components through a single metal layer. However, in alternate arrangements, at least some of the interconnects pass through multiple metal layers and/or "zig zag" through the layers between the circuit components. Moreover, depending on the configuration (i.e., the particular components and arrangements of those components) of a given change detection circuit 106, ion-sensitive element 104 (e.g., an inductor or capacitor) could couple to a gate, drain, or source of a transistor component or to a capacitor, inductor or resistor component of change detection circuit 106.

Interface 108 can be any suitable parallel or serial interface with mechanical, electrical and/or optical and logical signals and a communication protocol for sequencing the operation of interface 108 and exchanging information with CPU 110. Interface 108 can transmit and receive data and can include components for signal processing and formatting according to the communication protocol being used. A memory or buffer can be included in interface 108 to aid synchronization and sequence control. Furthermore, interface 108 can include a current source for supplying RF ion-sensitive element 104 and change detection circuit 106 with electrical energy.

CPU 110 may comprise one or more microprocessors and/or one or more digital signal processors. Memory 112 may be coupled to CPU 110 and may comprise a read-only memory (ROM), a random-access memory (RAM), a programmable ROM (PROM), and/or an electrically erasable programmable read-only memory (EEPROM). Memory 112 may include multiple memory locations for storing, *inter alia,* an operating system, data and variables for programs executed by CPU 110; computer programs for causing the processor to operate in connection with various functions; a database for other miscellaneous information used by CPU 110; and other suitable information. The computer programs may be stored, for example, in ROM, PROM or flash EEPROM and may direct CPU 110 in controlling the operation of RF ion sensor system 100.

CPU 110 may be programmed for frame reception processing. A frame can be received via the transceiver 118 in accordance with known techniques. For example, CPU 110 can issue a read frame request. CPU 110 can be aware that a frame was received in various ways, for example, the processor can wait for reception of the frame, or an interrupt can indicate that the frame is received, or the like.

Transceiver 118 includes an antenna to transmit and receive communications when operably connected to a communication network. Responsive to signaling from transceiver 118, upon execution of instructions by CPU 110, or automatically upon receipt of certain information via transceiver 118, RF interface 114 can begin performing a frame check sequence (FCS) to determine whether a received frame has an error. RF interface 114 can provide the FCS result in an appropriate way for CPU 110 to obtain the FCS result. For example, the FCS result can be provided in a specific register or location in memory 112, where it can be obtained by CPU 110. The FCS result can alternatively be obtained by request to RF interface 114, upon an alert mechanism to CPU 110, or the like. Accordingly, one or more embodiments includes a component for performing a frame check sequence responsive to the at least one frame, and providing a result of the performing as the frame check sequence result.

CPU 110 can turn the transceiver 118 from receive to transmit, and/or from transmit to receive, automatically upon receipt of pre-determined information via transceiver 118, or upon execution of instructions by CPU 110, or responsive to signaling from transceiver 118.

I/O interface 116 can be used in addition to, or instead of, RF interface 114 and transceiver 118. I/O interface 116 can be optical, wired or wireless and is driven by CPU 110 and includes circuitry and logic to interpret a device address generated by CPU 110, to generate interrupts, and to implement handshaking and data transfer using a suitable parallel or serial communication protocol. Various types of peripheral devices can be configured to communicate with RF ion sensor system 100 including, for example, a keyboard, display, mouse, touch screen, printer, external memory, external processing system, and/or speaker, among others.

In other embodiments of RF ion sensor system 100, interface 108 may be connected or coupled directly to RF interface 114 and/or I/O interface 116 instead of using CPU 100 as an intermediary between the components. In still further embodiments, RF ion-sensitive element 104 can be coupled directly to a second transceiver (not shown) and configured to change the variable frequency of the second transceiver.

Alternative arrangements of RF ion-sensitive element 104 and change detection circuit 106 and the coupling between these circuits are possible. For example, in one alternative embodiment, instead of being included on a single IC chip, RF ion-sensitive element 104 and change detection circuit 106 are each included on separate IC chips or together on a common IC separate from the IC containing the CPU and other components, but still contained within the same IC packaging. This packaging could include plastic or ceramic packaging enclosing the chips, a printed circuit board having mounted thereon the separate chips; etc.

RF ion-sensitive element 104 interacts with a fluid, which effects a change to an intrinsic property or properties of RF ion-sensitive element 104. More particularly, the electrically conductive free ions within the fluid change one or more intrinsic properties of RF ion-sensitive element 104 such as a self-inductance of an inductor and/or the quality factor within RF ion-sensitive element 104, a capacitance of a capacitor within RF ion-sensitive element 104, and/or a resonant frequency of an LC circuit within RF ion-sensitive element 104. Accordingly, it can be said that the RF ion-sensitive element 104 is sensing a property of the fluid instead of RF ion-sensitive element 104 itself.

Change detection circuit 106 determines a change in a property of RF ion-sensitive element 104 associated with the interaction of RF ion-sensitive element 104 with the fluid. For example, this involves, prior to allowing the RF ion-sensitive element 104 to interact with the fluid, determining known values (e.g., a known resonant frequency, inductance value, quality factor, capacitance value, etc.) for the properties of RF ion-sensitive element 104 that will be tracked by change detection circuit 106, which is referred to herein as a known calibration state.

In one embodiment, RF ion-sensitive element 104 properties are measured and the values stored within the IC package containing RF ion-sensitive element 104. In selected embodiments, the measured values are stored within memory device 112 (e.g., flash memory). Accordingly, change detection circuit 106 determines or measures the particular property of RF ion-sensitive element 104 when it interacts with the fluid, and compares this measured value to the corresponding stored values to determine the change in the property for RF ion-sensitive element 104 as a result of its interaction with the fluid. In a related embodiment, RF ion-sensitive element 104 properties are trimmed to a desired value before it is allowed to interact with the fluid. Change detection circuit 106 then measures the difference between the initial trimmed property value and the value of the property after the start of the interaction between the fluid and RF ion-sensitive element 104.

In other selected embodiments, the IC package containing RF ion-sensitive element 104 also includes a reference circuit formed on the substrate and coupled to change detection circuit 106, wherein the reference circuit is configured to match the RF ion-sensitive element 104 in a known calibration state. However, the reference circuit is not allowed to interact with the fluid. Accordingly, change detection circuit 106 determines or measures the particular property of RF ion-sensitive element 104 when it interacts with the fluid, and compares this measured value to the corresponding value for the same property of the reference circuit, to determine the change in the property of RF ion-sensitive element 104 as a result of its interaction with the fluid. This embodiment allows change detection circuit 106 to generate more accurate determinations over time and temperature variations, for instance, of RF ion-sensitive element 104.

Change detection circuit 106 determines the sensed property of the fluid using the determined change in the property of RF ion-sensitive element 104. In an embodiment, a database is built off-line that stores the characteristics or properties (e.g., ion concentration, frequency response, etc.) for different fluids and fluid concentrations at different frequencies for a given configuration of RF ion-sensitive element 104. The fluid properties and characteristics data from this database can be stored within memory 112 or other suitable component. During operation, change detection circuit 106 is used to compare a measured response to the stored data for one or more fluids to determine a property of the fluid such as the type of fluid or a concentration of a particular ion within the fluid. The local database could also be supplemented with a remote database.

In other selected embodiments, the fluid can be manipulated and changes to the property of RF ion-sensitive element 104 are measured to determine a property of the fluid. One example is the use of temperature change or the addition of reactants to change the composition of the fluid, especially its ionic composition. Continuous measurement of the behavior of the fluid and its ions allows progress of the reaction to be monitored. Using the appropriate database, additional inferences about fluid properties can be made. If a stimulus is introduced into the fluid at a known distance from RF ion sensor system 100 and the time delay between the introduction of the stimulus and the observation of a change in fluid properties is measured, the relevant flow rate of the fluid and species within it can be measured. In one example implementation, the fluid is heated to determine a flow rate of the ions within the fluid, which can then be used, for instance, to identify the type of ions and perhaps the concentration of ions within the fluid. For the flow rate example, a heater is positioned near or within the fluid at a known distance from RF ion sensor system 100. Upon using the heater to increase the temperature of the fluid, the fluid properties close to the heater can be changed. An internal clock can measure the delay between the onset of heating and the time that the RF ion sensor system 100 senses a change in the fluid due to the temperature change. Since distance and time are now known, flow rate can be determined.

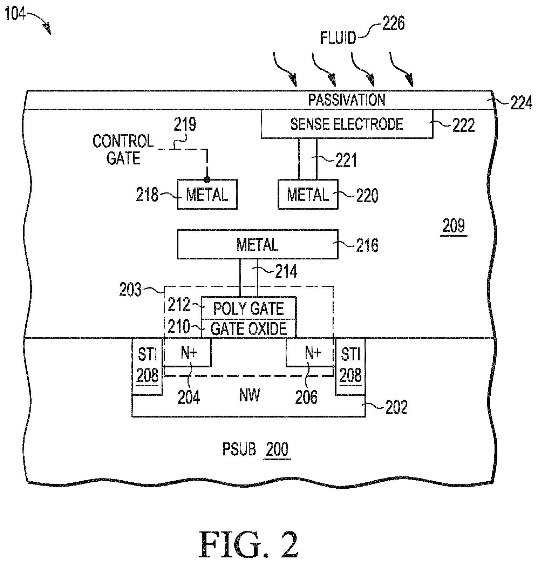

FIG. 2 is a conceptual cross-sectional view of RF ion-sensitive element 104 that can be used in RF ion sensor system 100 of FIG. 1, in accordance with selected embodiments. RF ion-sensitive element 104 includes varactor 203 formed on substrate 200 and capacitively coupled to sense electrode 222 through metal portions 216, 218, 220 formed in layers of dielectric material 209. Some portions of varactor 203 are formed directly in substrate 200 including source/drain regions 204, 206 (also referred to as current electrodes) in well 202 of substrate 200 through doping and ion implantation. Shallow trench isolation (STI) regions 208 can be formed between doped regions of substrate 202, for example a first STI region 208 is formed on one side of current electrode 204 at an outer edge of well 202 and a second STI region 208 is formed on one side of current electrode 206 at an opposite outer edge of well 202. Other portions of the varactor 203 such as gate dielectric or oxide 210 and gate polysilicon 212 are formed by other layers deposited or formed on substrate 200. Gate dielectric 210 and gate polysilicon 212 can include one or more layers of polysilicon, dielectric, and/or metal layers in various types, amounts and combinations.

In the embodiment shown, substrate 200 has a P-type polarity. Current electrodes 204, 206 and well 202 have an N-type polarity, with current electrodes 204, 206 being more heavily doped than well 202.

Passivation layer 224 is deposited over dielectric material 209 and sense electrode 222 and comprises a coating of material to create a shell against corrosion. Passivation layer 224 can be any combination of (i.e., at least one of) silicon oxide, silicon nitride, or silicon oxynitride having a "standard" thickness on the order of *u*m or hundreds of nm. For example, for pH sensing, passivation layer 224 is exposed to fluid 226. However, to detect specific ions, such as calcium or potassium for example, a layer of other material may be deposited over passivation layer 224 or may replace passivation layer 224 over sense electrode 222.

Sense electrode 222 is formed in a last metal layer. Metal portions 218 and 220 are formed in a metal layer below the last metal layer. Metal portion 216 is formed in a metal layer between metal portions 218, 220 and polysilicon gate 212 of varactor 203.

Sense electrode 222 is formed of a conductive material such as metal that interacts with fluid 226 such as by contacting, penetrating or extending a given depth into fluid 226. Fluid 226 affects a change to the voltage on sense electrode 222, which in turn affects capacitance of gate oxide 210 through the capacitive coupling between sense electrode 222, metal portions 220, 216, and n-well 202. Sense electrode 222 is communicatively coupled to metal layer 220 by direct electrical connection such as vias, interconnects, or wires 221 in one or more of dielectric layer(s) 209. Metal portion 216 is communicatively coupled to gate polysilicon 212 by direct electrical connection such as vias, interconnects, or wires 214 in one or more of dielectric layer(s) 209.

Note that metal portion 218 is optional but can be included to adjust the sensitivity of RF ion-sensitive element 104. As shown, conductive lead 219 is directly connected between metal portion 218 and a voltage source (not shown) that can be controlled to bias varactor 203 to a desirable operating condition to obtain maximum sensitivity of RF ion-sensitive element 104. Conductive lead 219 can also be used to trim the varactor 203 to reduce manufacturing process induced variations. The voltage source for conductive lead 219 can be controlled by feedback and control logic in CPU 110 or other suitable component that monitors data from change detection circuit 106.

The sense electrode 222 and the varactor 203 are communicatively coupled to enable varactor 203 to indicate a change in its property through the sense electrode 222 as results from its interaction with fluid 226. The change in potential at sense electrode 222 causes a change in potential at gate 212 through coupling between metal layers 220 and 216. The change in potential at gate 212 causes a change in the capacitance of varactor 203. The change in capacitance of varactor 203 is then detected by change detection circuit 106.

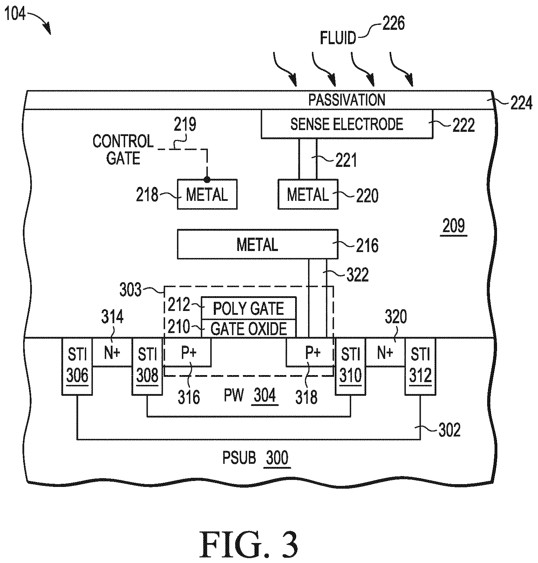

FIG. 3 is a conceptual cross-sectional view of RF ion-sensitive element 104 that can be used in RF ion sensor system 100 of FIG. 1, in accordance with selected embodiments that uses a body or well 304 of substrate 300 instead of gate 212 to sense a change in capacitance. RF ion-sensitive element 104 includes substrate 300 with P-type polarity. Varactor 303 is formed on P-well 304 with P-type polarity and includes electrodes 316, 318 with P-type polarity, gate dielectric or oxide 210, and gate polysilicon 212 formed by layers deposited or formed on substrate 300. Gate dielectric 210 and gate polysilicon 212 can include one or more layers of polysilicon, dielectric, and/or metal layers in various types, amounts and combinations.

Deep N-well 302 is implanted with N-type polarity in substrate 300. P-well 304 is implanted in deep N-well 302. Electrodes 314, 320 are formed in deep N-well 302. Electrode 314 is formed between shallow trench isolation (STI) regions 306 and 308. Electrode 316 is formed between STI 308 and a channel region of P-well 304, Electrode 318 is formed between the channel region of P-well 304 and STI 310, and electrode 320 is formed between STI 310 and STI 312. The doping of current electrodes 316, 318 is higher than the doping of P-well 304, and the doping of electrodes 314, 320 is higher than the doping of deep N-well 302.

Metal portions 216, 218, 220 formed in layers of dielectric material 209. Passivation layer 224 or other suitable material is deposited over dielectric material 209 and sense electrode 222 and comprises a coating of material to create a shell against corrosion. Passivation layer 224 can be any combination of (i.e., at least one of) silicon oxide, silicon nitride, or silicon oxynitride having a "standard" thickness on the order of *u*m or hundreds of nm.

Sense electrode 222 is formed in a last metal layer. Metal portions 218 and 220 are formed in a metal layer below the last metal layer. Metal portion 216 is formed in a metal layer between metal portions 218, 220 and polysilicon gate 212 of varactor 303.

Metal portion 216 is communicatively coupled to current electrode 318 by direct electrical connection such as vias, interconnects, or wires 322 in one or more of dielectric layer(s) 209. Sense electrode 222 is communicatively coupled to metal portion 220 by direct electrical connection such as vias, interconnects, or wires 221.

Sense electrode 222 is formed of a conductive material such as metal that interacts with fluid 226 such as by contacting, penetrating or extending a given depth into fluid 226. Fluid 226 -causes a change to the voltage on sense electrode 222, which in turn affects voltage of P-well 304 through the capacitive coupling between sense electrode 222 and metal portion 216.

Note that metal portion 218 is optional but can be included to adjust the sensitivity of RF ion-sensitive element 104. As shown, conductive lead 219 is directly connected between metal portion 218 and a voltage source (not shown) that can be controlled to bias varactor 303 to a desirable operating condition to obtain maximum sensitivity of RF ion-sensitive element 104. The voltage source for conductive lead 219 can be controlled by feedback and control logic in CPU 110 or other suitable component that monitors data from change detection circuit 106.

Sense electrode 222 and the varactor 303 are communicatively coupled to enable varactor 303 to indicate a change in its property through the sense electrode 222 as results from its interaction with fluid 226. The change in potential at sense electrode 222 causes a change in potential at gate 212 through coupling between metal layers 220 and 216. The change in potential at gate 212 causes a change in the capacitance of varactor 303. The change in capacitance of varactor 303 is then detected by change detection circuit 106.

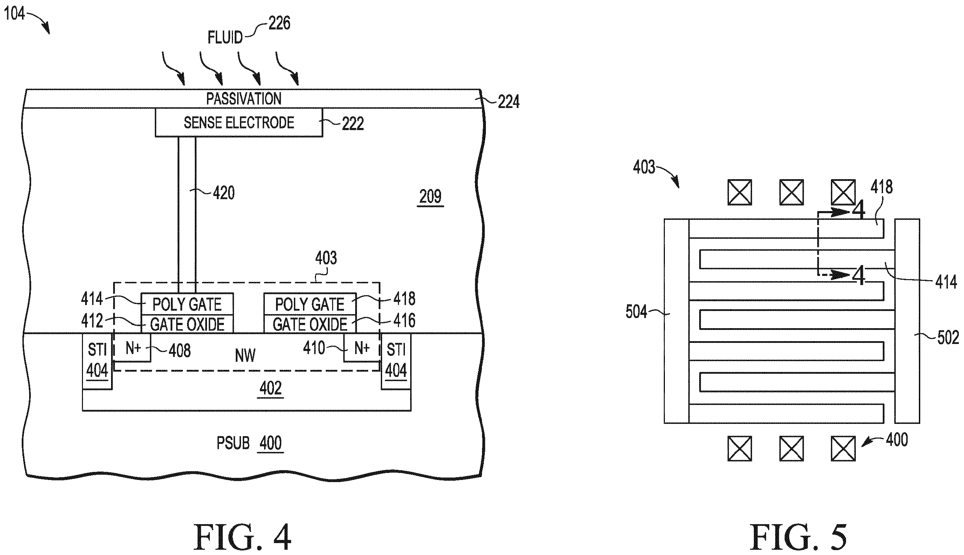

FIG. 4 is a conceptual cross-sectional view of RF ion-sensitive element 104 that can be used in RF ion sensor system 100 of FIG. 1, in accordance with selected embodiments that uses a differential varactor configuration to detect ions in fluid 226. RF ion-sensitive element 104 includes varactor 403 formed on substrate 400 with polysilicon gate 414 capacitively coupled to sense electrode 222 through vias, interconnects, or wires 420 formed in layers of dielectric material 209. Some portions of varactor 403 are formed directly in substrate 400 including source/drain regions 408, 410 (also referred to as current electrodes) in well 402 of substrate 400 through doping and ion implantation. Shallow trench isolation (STI) regions 404 can be formed between doped regions of substrate 402, for example a first STI region 404 is formed on one side of current electrode 408 at an outer edge of well 402 and a second STI region 404 is formed on one side of current electrode 410 at an opposite outer edge of well 402. Other portions of the varactor 403 such as gate dielectric or oxide 412 and gate polysilicon 414 are formed by other layers deposited or formed on substrate 400. Gate dielectric 412 and gate polysilicon 414 can include one or more layers of polysilicon, dielectric, and/or metal layers in various types, amounts and combinations.

In the embodiment shown, substrate 400 has a P-type polarity. Current electrodes 408, 410 and well 402 have an N-type polarity, with current electrodes 408, 410 being more heavily doped than well 402.

Passivation layer 224 or other suitable material is deposited over dielectric material 209 and sense electrode 222 and comprises a coating of material to create a shell against corrosion. Passivation layer 224 can be any combination of (i.e., at least one of) silicon oxide, silicon nitride, or silicon oxynitride having a "standard" thickness on the order of *u*m or hundreds of nm.

Sense electrode 222 is formed in a last metal layer of a conductive material such as metal that interacts with fluid 226 such as by contacting, penetrating or extending a given depth into fluid 226. Fluid 226 effects a change to the voltage on sense electrode 222, which in turn affects capacitance of gate oxide 412 through the coupling between sense electrode 222 and gate 414. Sense electrode 222 is communicatively coupled to polysilicon gate 414 by direct electrical connection such as vias, interconnects, or wires 420 in one or more of dielectric layer(s) 209.

Sense electrode 222 and varactor 403 are communicatively coupled to enable varactor 403 to indicate a change in its property through the sense electrode 222 as results from its interaction with fluid 226. Ions in fluid 226 modulate the voltage at gate 414, which results in a change of the total capacitance between gate 414 and gate 418 that can be detected by change detection circuit 106. The total capacitance in this case is the series combination of 2 separate capacitances: capacitance between gate 414 and well 402, and the capacitance between well 402 and gate 418.

In selected embodiments, capacitance between gate 418 and well 402 can be used as a reference capacitor. Since gate 418 is not electrically connected to sense electrode 222, gate 418 is not affected by the interaction of the sense electrode 222 with fluid 226. Therefore, the capacitance between gate 418 and well 402 is not affected by the fluid 226. Gate 414, which is affected by the interaction of sense electrode 222 with fluid 226, changes the capacitance between gate 414 and well 402. The modified capacitance between gate 414 and well 402 can be compared with the reference capacitance between gate 418 and well 402. The difference in these two capacitance values can be used to measure the property of fluid 226.

FIG. 5 is a conceptual top view of an embodiment of a varactor 403 that can be used in the ion sensor of FIG. 4 comprising interdigitated gate 502/504, where the capacitor between gate 414 or plate 502 and well 402 is coupled to sensing plate 222. The capacitor between gate 418 or plate 504 and well 402 is not directly coupled to the sense electrode 222 and can be used as the reference capacitor.

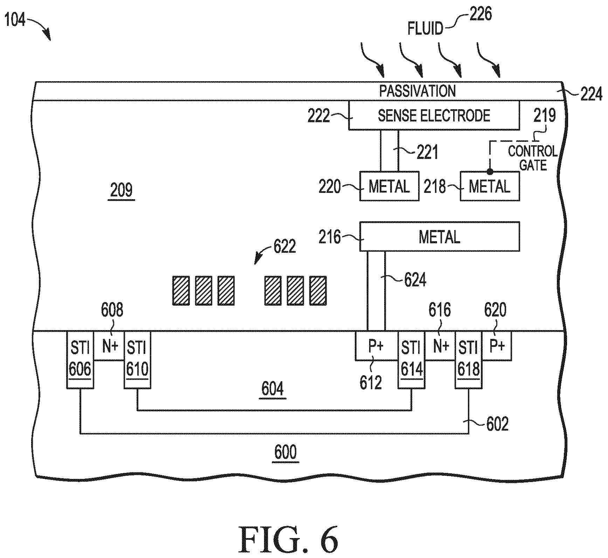

FIG. 6 is a conceptual cross-sectional view of an RF ion sensitive element 104 for sensing one or more properties of a fluid, in accordance with other selected embodiments, with an inductor 622 and a body or well 604 of substrate 600. RF ion-sensitive element 104 includes substrate 600 with P-type polarity. Substrate 600 includes deep N-well 602 implanted with N-type polarity. P-well 604 is implanted in deep N-well 602. Electrodes 608, 616 with N-type polarity are formed in deep N-well 602. Electrode 612 with P-type polarity is formed in P-well 604. Electrode 620 with P-type polarity is formed in substrate 600. N-type electrode 608 is formed between shallow trench isolation (STI) regions 606 and 610. A portion of P-well separates STI 610 from P-type electrode 612 and P-type electrode 612 is implanted in P-well 604. Electrode 616 is implanted between STI 614 and STI 618. Electrode 620 is implanted on a side of STI 618 that is opposite to N-type electrode 616. The doping of P-type electrodes 612, 620 is higher than the doping of P-well 604 and P-type substrate 600, and the doping of electrodes 608, 616 is higher than the doping of deep N-well 602.

Inductor 622 can be built in a poly layer, a metal layer, or a combination of poly and metal layers. In the embodiment shown, inductor 622 is a coil formed with electrically conductive material in a metal layer that is separated from P-well 604 by one or more of dielectric layers 209.

Dielectric layer(s) 209, metal portions 216, 218, 220, sense electrode 222, electrical connections 221, control gate 219, passivation layer 224, and fluid 226 are the same or similar to those shown in FIG. 2 and described previously herein, except metal portion 216 is communicatively coupled to P-type electrode 612 by direct electrical connection such as vias, interconnects, or wires 624 in one or more of dielectric layer(s) 209.

Ion interactions from sense electrode 222 modulate resistivity of P-well 604 and thereby influence characteristics of inductor 622. When inductor 622 is built in a first or bottommost metal layer, inductor 622 will be more influenced by P-well 604 and have higher sensitivity than when built in an upper metal layer. Through capacitive coupling, the ions in fluid 226 will effect a change in the potential in the P-well 604, which in turn will change the resistance of the P-well 604 and the quality factor Q of inductor 622. Any circuit technique used to detect these changes will, thus, be detecting properties of the fluid.

The geometry of inductor 622 is defined by one or more of the following parameters: the number of turns of inductor 622; the spacing in between the turns; one or more characteristic diameters of inductor 622 and the shape of the inductor. Additionally, P-well 604 can be coupled to a metal portion 218, which allows use of a control gate to reverse bias P-well 604 to a suitable operating point for maximum sensitivity. Note that a relatively shallow, highly resistive isolated P-well 604 will allow more efficient conductivity modulation from the ion interaction.

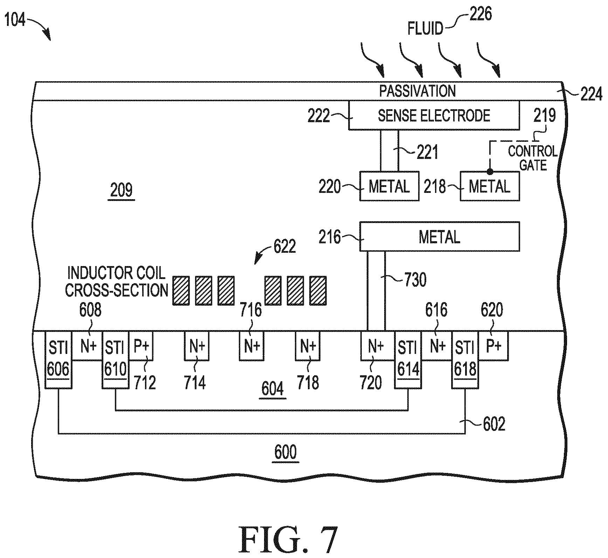

Similar to the embodiment of RF ion-sensitive element 104 shown in FIG. 6, FIG. 7 is a conceptual cross-sectional view of an RF ion sensitive element 104 in accordance with other selected embodiments, with an inductor 622, bias strips 714-720 of N-type polarity implanted in P-well 604 at an upper surface of substrate 600 to cause or affect a change in the inductor characteristics, predominantly the quality factor Q. Substrate 600, deep N-well 602, P-well 604, N-type electrodes 608, 616, P-type electrode 620, STI regions 606, 610, 614, 618, inductor 622, dielectric layer(s) 209, metal portions 216, 218, 220, sense electrode 222, electrical connections 221, control gate 219, passivation layer 224, and fluid 226 are the same or similar to those shown in FIG. 6 and described previously herein, except metal portion 216 is communicatively coupled to N-type electrode 720 by direct electrical connection such as vias, interconnects, or wires 730 in one or more of dielectric layer(s) 209. N-type bias strip 720 is implanted in P-well next to STI 614. Additionally, electrode 712 with P-type polarity is implanted in P-well 604 next to STI 610.

Bias strips 714-720 are connected together and coupled to sense electrode 222 by electrical connection 730. Ion interaction through sense electrode 222 modulates depletion regions between N-type bias strips 714-720 and P-well 604, which changes the resistivity of P-well 604 and the parasitics of inductor 622. The resulting change in the characteristics of inductor 622 can be used to detect the ion concentration of fluid 226.

By now it should be appreciated that integration of the sensor, fluid property measurement circuits, and communication components in the same integrated circuit package enables better measurement sensitivity than previously available sensors. Embodiments of the present teaching can be implemented using conventional CMOS technology. This allows the cost to be minimized and the scope of applications that utilize such embodiments to be maximized. The integration of all the components in conventional CMOS enables and simplifies further integration of digital processing power and non-volatile storage of relevant algorithms and parameters so that complete end-to-end measurement, processing and actuation can be executed by a single integrated circuit package. Moreover, non-expert users can utilize these packages since the available expert knowledge is now captured in the stored algorithms and database, as well as allowing the data to be transmitted wirelessly to the desired recipient.

In the foregoing specification, specific embodiments have been described. However, one of ordinary skill in the art appreciates that various modifications and changes can be made without departing from the scope of the invention as set forth in the claims below. Accordingly, the specification and figures are to be regarded in an illustrative rather than a restrictive sense, and all such modifications are intended to be included within the scope of present teachings.

For the sake of brevity, conventional techniques related to semiconductor fabrication (including those using conventional CMOS technology), CMOS devices, MOSFETs, ion-sensitive devices, inductors (L), capacitors (C), and LC circuits (also referred to herein as LC tanks), frequency sensing circuits, and other functional aspects of the systems (and the individual operating components of the systems) may not be described in detail. Furthermore, the connecting lines shown in the various figures contained herein are intended to represent example physical and/or electrical couplings between the various elements. It should be noted that many alternative or additional physical or electrical connections, such as wireless connections, may be present in a practical embodiment.

Embodiments may include combinations of features recited in the following numbered clauses:
1. An ion sensor for sensing ions in a fluid, comprising: a Metal-Oxide Semiconductor (MOS) varactor formed in and on a semiconductor substrate having a gate dielectric over the semiconductor substrate, a gate over the gate dielectric, a well region in the substrate under the gate dielectric, and source/drain regions in the well region, wherein the well region and the source/drain regions are of a same conductivity type; and a sense electrode coupled to the MOS varactor, wherein the capacitance of the gate of the varactor changes when the sense electrode interacts with ions in the fluid.
2. The ion sensor of clause 1, wherein the sense electrode is coupled to the gate of the varactor.
3. The ion sensor of clause 1, wherein the well region is characterized as an isolated N-type well and the source/drain regions are N-type.
4. The ion sensor of clause 3, wherein the substrate is a P-type substrate.
5. The ion sensor of clause 1, further comprising metal interconnect layers between the varactor and the sense electrode.
6. The ion sensor of clause 5, wherein the sense electrode is in a top metal layer.
7. The ion sensor of clause 1, further comprising a first metal portion isolated from the sense electrode and capacitively coupled to the gate of the varactor.
8. The ion sensor of clause 7, wherein the first metal portion forms a control gate to adjust a threshold voltage of the varactor.
9. The ion sensor of clause 1, wherein the sense electrode is coupled to the well region of the varactor.
10. The ion sensor of clause 9, wherein the well region is characterized as an isolated P-type well and the source/drain regions are P-type.
11. The ion sensor of clause 10, wherein the semiconductor substrate is a P-type substrate, and the isolated P-well is located within an N-type well within the substrate.
12. The ion sensor of clause 1, wherein the ion sensor further comprises:
   a second gate dielectric over the semiconductor substrate, and
   a second gate over the second gate dielectric.
13. The ion sensor of clause 12, wherein the gate of the varactor comprises a first plate of an inter-digitated capacitor and the second gate comprises a second plate of the inter-digitated capacitor, and wherein a total capacitance of the gate and the second gate changes when the sense electrode interacts with ions in the fluid.
14. The ion sensor of clause 12, wherein the gate of the varactor comprises a first plate of a sensing capacitor and the well region comprises a second plate of the sensing capacitor, and wherein the second gate comprises a first plate of a reference capacitor and the well region comprises a second plate of the reference capacitor.
15. The ion sensor of clause 1, further comprising a passivation layer over the sense electrode.
16. The ion sensor of clause 1, further comprising a measurement circuit configured to determine the change in the capacitance of the gate.
17. An ion sensor for sensing ions in a fluid, comprising:
   a dielectric layer over a semiconductor substrate; an inductor within the dielectric layer, wherein the inductor is over a well region within the semiconductor substrate of a first conductivity type; a sense electrode coupled to the well region, wherein a resistance of the well region changes when the sense electrode interacts with ions in the fluid, affecting a change in a quality factor of the inductor.
18. The ion sensor of clause 17, further comprising a measurement circuit configured to determine the change in the quality factor of the inductor.
19. The ion sensor of clause 17 further comprising well regions of a second conductivity type, opposite the first conductivity type, in the well region of the first conductivity type, wherein the well regions of the second conductivity type are coupled to each other.
20. The ion sensor of clause 17, further comprising a plurality of interconnect layers between the substrate and the sense electrode, wherein the sense electrode is the top interconnect layer and the inductor is in an interconnect layer of the plurality of interconnect layers closest to the substrate.

An ion sensor for sensing ions in a fluid includes a Metal-Oxide Semiconductor (MOS) varactor formed in and on a semiconductor substrate having a gate dielectric over the semiconductor substrate, a gate over the gate dielectric, a well region in the substrate under the gate dielectric, and source/drain regions in the well region, wherein the well region and the source/drain regions are of a same conductivity type; and a sense electrode coupled to the MOS varactor, wherein the capacitance of the gate dielectric of the varactor changes when the sense electrode interacts with ions in the fluid. Alternatively, resistance of the well region changes when the sense electrode interacts with ions in the fluid, affecting a change in a quality factor of an inductor.

The benefits, advantages, solutions to problems, and any element(s) that may cause any benefit, advantage, or solution to occur or become more pronounced are not to be construed as a critical, required, or essential features or elements of any or all the claims. The invention is defined solely by the appended claims including any amendments made during the pendency of this application and all equivalents of those claims as issued.

In this document, the terms "comprises," "comprising," "has", "having," "includes", "including," "contains", "containing", "made of' or any other variation thereof, are intended to cover a non-exclusive inclusion, such that a process, method, article, or apparatus that comprises, has, includes, contains, is made of a list of elements does not include only those elements but may include other elements not expressly listed or inherent to such process, method, article, or apparatus. The terms "substantially", "essentially", "approximately", "about" or any other version thereof, are defined as being close to as understood by one of ordinary skill in the art, and in one non-limiting embodiment the term is defined to be within 10%, in other selected embodiments within 5%, in other selected embodiments within 1% and in other selected embodiments within 0.5%.

As used herein, the terms "configured to", "configured with", "arranged to", "arranged with", "capable of" and any like or similar terms mean that the referenced circuit elements have an internal physical arrangement (such as by virtue of a particular transistor or fabrication technology used) and/or physical coupling and/or connectivity with other circuit elements in an inactive state. This physical arrangement and/or physical coupling and/or connectivity (while in the inactive state) enable the circuit elements to perform stated functionality while in the active state of receiving and processing various signals or inputs to the circuit elements. A device or structure that is "configured" in a certain way is configured in at least that way, but may also be configured in ways that are not listed.

The above description refers to elements, nodes or features being "connected" or "coupled" together. As used here and, unless expressly stated otherwise, "coupled" means that one element, node or feature is directly or indirectly joined to (or is in direct or indirect communication with) another element, node or feature, and not necessarily physically. As used herein, unless expressly stated otherwise, "connected" means that one element, node or feature is directly joined to (or is in direct communication with) another element, node or feature. Furthermore, although the various circuit schematics shown herein depict certain example arrangement of elements, additional intervening elements, devices, features, or components may be present in an actual embodiment (assuming that the functionality of the given circuit is not adversely affected).

In the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. An ion sensor for sensing ions in a fluid, comprising:
a Metal-Oxide Semiconductor (MOS) varactor formed in and on a semiconductor substrate having a gate dielectric over the semiconductor substrate, a gate over the gate dielectric, a well region in the substrate under the gate dielectric, and source/drain regions in the well region, wherein the well region and the source/drain regions are of a same conductivity type; and
a sense electrode coupled to the MOS varactor, wherein the capacitance of the gate of the varactor changes when the sense electrode interacts with ions in the fluid.

2. The ion sensor of claim 1, wherein the sense electrode is coupled to the gate of the varactor.

3. The ion sensor of claim 1 or 2, wherein the well region is characterized as an isolated N-type well and the source/drain regions are N-type.

4. The ion sensor of any preceding claim, wherein the substrate is a P-type substrate.

5. The ion sensor of any preceding claim, further comprising metal interconnect layers between the varactor and the sense electrode.

6. The ion sensor of any preceding claim, wherein the sense electrode is in a top metal layer.

7. The ion sensor of any preceding claim, further comprising a first metal portion isolated from the sense electrode and capacitively coupled to the gate of the varactor.

8. The ion sensor of claim 7, wherein the first metal portion forms a control gate to adjust a threshold voltage of the varactor.

9. The ion sensor of claim 1, wherein the sense electrode is coupled to the well region of the varactor.

10. The ion sensor of claim 9, wherein the well region is characterized as an isolated P-type well and the source/drain regions are P-type.

11. The ion sensor of claim 9 or 10, wherein the semiconductor substrate is a P-type substrate, and the isolated P-well is located within an N-type well within the substrate.

12. The ion sensor of any preceding claim, wherein the ion sensor further comprises:
a second gate dielectric over the semiconductor substrate, and
a second gate over the second gate dielectric.

13. The ion sensor of claim 12, wherein the gate of the varactor comprises a first plate of an inter-digitated capacitor and the second gate comprises a second plate of the inter-digitated capacitor, and wherein a total capacitance of the gate and the second gate changes when the sense electrode interacts with ions in the fluid.

14. The ion sensor of 12 or 13, wherein the gate of the varactor comprises a first plate of a sensing capacitor and the well region comprises a second plate of the sensing capacitor, and wherein the second gate comprises a first plate of a reference capacitor and the well region comprises a second plate of the reference capacitor.

15. The ion sensor of any preceding claim, further comprising a measurement circuit configured to determine the change in the capacitance of the gate.
